# EUROPÄISCHE PATENTSCHRIFT

(11) **EP 1 092 946 B1**
(45) Veröffentlichungstag und Bekanntmachung des Hinweises auf die Patenterteilung: **08.12.2004**
(21) Anmeldenummer: 00121944.3
(22) Anmeldetag: 09.10.2000
(51) Int. Cl.: G01B 11/06, H01L 21/00

(54) **Hochgenauer Maskenhalter zur Dickenmessung und Verfahren zur Bestimmung von Dickenabweichungen**
High precision mask holder for measuring thickness and procedure for determining thickness deviations
Support de masque très précis pour mesurer l'épaisseur et procédé de détermination des différences de l'épaisseur

(30) Priorität: 11.10.1999 DE 19948797
(43) Veröffentlichungstag der Anmeldung: 18.04.2001
(73) Patentinhaber: Leica Microsystems Semiconductor GmbH, 35578 Wetzlar (DE)
(72) Erfinder: Bläsing-Bangert, Carola, 35625 Hüttenberg (DE); Kaczynski, Ulrich, 61231 Bad Nauheim (DE)
(74) Vertreter: Reichert, Werner F., Dr.

(56) Entgegenhaltungen:
- EP-A- 1 014 030
- WO-A-99/57508
- US-A- 5 671 054

## Beschreibung

Die Erfindung betrifft einen Substrathalter und dessen Verwendung sie betrifft auch ein Verfahren zur Bestimmung der Dickenabweichung einer Subtrats. Im Besonderen betrifft die Erfindung einen Substrathalter, der derart ausgestaltet ist, dass er für eine definierte Auflage eines Substrats geeignet ist und dabei zur Erhöhung der Messgenauigkeit des hochgenauen Messgeräts beiträgt.

Aus der Patentschrift US-A-5,671,054 ist ein Verfahren und eine Vorrichtung zum Bestimmen der Position von Mustern auf Substraten bekannt, die eine bestimmte Dicke aufweisen. Das Substrat wird dabei auf einen Messtisch aufgelegt, der zur Unterstützung des Substrats drei definierte punktförmige Unterstützungselemente aufweist. Zur Bestimmung der Dicke des Substrats wird ein Referenzsubstrat verwendet, das zuerst vermessen wird. Anschließend wird das zur Messung vorgesehene Substrat vermessen. Ein Datenverarbeitungselement errechnet dann aus den Unterschieden zwischen Referenzsubstrat und zu vermessenden Substrat die entsprechenden Dickenunterschiede und bezieht diese für die weitere Positionsbestimmung des Musters in die Rechnung mit ein. Diese Anordnung hat jedoch einen erheblichen Nachteil darin, dass sie nicht sehr flexibel ist, da hier nur feste Maskengrößen verwendet bzw. vermessen werden können. Des Weiteren ist es problematisch, dass sich, falls Masken mit unterschiedlicher Maskendicke vermessen werden sollen, die Fokusebene ändert und nicht mehr exakt auf der Oberfläche des Substrats befindet.

Aus dem Artikel "Advanced Mask Metrology System for up to 4 Gbit DRAM", veröffentlicht in SPIE, Vol. 3096-0277-786X/97 (Seiten 433-444), ist ebenfalls ein Substrathalter bekannt. Hier wird ein universeller Substrathalter vorgestellt, der entsprechend der verschiedenen Größe der verwendeten Substrattypen die Auflagepunkte bzw. die Auflageelemente auf der Substrathalteroberfläche entsprechend angeordnet hat. Die Auflageelemente sind derart ausgestaltet, dass sie sich in ihrer Höhe unterscheiden. So sind die Auflageelemente für die Substrate mit den kleineren Abmessungen nicht so hoch wie die Auflageelemente für Substrate mit größeren Abmessungen. Ein Nachteil dieses Substrathalters ist, dass er nicht für Durchlicht geeignet ist.

Es ist daher Aufgabe der vorliegenden Erfindung, einen Substrathalter zu schaffen, der für die Vermessung bei Durchlicht geeignet ist und dabei eine definierte Auflage für die Substrate bereitstellt.

Diese Aufgabe wird erfindungsgemäß gelöst durch einen Substrathalter nach dem Anspruch 1.

Eine weitere Aufgabe der Erfindung ist es, den Substrathalter in einem hochgenauen Messsystem zu verwenden, mit dem Substrate im Durchlicht vermessen werden können, und dass die dazu verwendeten Substrathalter für die Substrate eine definierte Auflage zur Verfügung stellen, und zur Bestimmung der Dickenabweichung eines Substrats von einer vorgegebenen Normdicke.

Diese Aufgabe wird nach dem Anspruch 6 gelöst.

Im Anspruch 7 ist ein Verfahren zur Bestimmung der Dickenabweichung eines substrats angegeben.

Der erfindungsgemäße Substrathalter bzw. die erfindungsgemäße Verwendung des Substrathalters ermöglichen ein Vermessen der Substrate sowohl im Auflicht als auch im Durchlicht. Die Substrathalter sind dabei derart ausgestaltet, dass alle Oberflächen der zu vermessenden Substrate auf einer gleichen Höhe liegen. Diese Höhe ist derart festgelegt, dass die Oberflächen der Substrate in der Abbéschen Ebene liegen, was den Abbé-Fehler minimiert. Die Substrathalter sind als Rahmen ausgestaltet, in dem eine Aussparung definiert ist, die durch einen umlaufenden Rand begrenzt wird. Am umlaufenden Rand der Aussparung sind Auflageelemente vorgesehen, an denen Punktauflagen ausgebildet sind. In einem bevorzugten Ausführungsbeispiel sind drei Auflagepunkte entsprechend entlang des umlaufenden Randes der Aussparung verteilt. Durch die Dreipunktauflage ergibt sich eine exakte Berechnung der Maskendurchbiegung, was eine exakte Berechnung und Korrektur der Lagedaten ermöglicht. Die Substrathalter sind derart gestaltet, dass für jeden Substrattyp ein anderer Substrathalter verwendet wird. Dabei sind die Außenabmessungen eines jeden Substrathalters gleich. Der Unterschied ergibt sich daraus, dass in den Substrathaltern die definierten Aussparungen sich entsprechend nach der Größe des verwendeten Substrattyps richten. Die Auflageelemente bzw. die dadurch zur Verfügung gestellten Punktauflagen sind am umlaufenden Rand der Aussparungen derart angeordnet, dass die flache Oberseite des Substrathalters mit der Oberfläche des Substrats fluchtet. Kleine Abweichungen von der Normdicke eines Substrattyps können dadurch korrigiert werden, dass zuerst mit der Optik des Messgeräts auf die Oberfläche des Substrats fokussiert wird und anschließend auf die flache Oberseite des Substrathalters. Aus dem Unterschied der Fokuslagen kann dann eine Dickenabweichung des Substrats ermittelt werden, die anschließend in die exakte Berechnung der Maskendurchbiegung eingeht. Ferner kann am Substrathalter eine Codierung angebracht werden, die eine individuelle Behandlung der Substrathalter durch die Mess- und Korrektur-Software ermöglicht. Eine Langzeitüberwachung (Driftüberwachung und eventuell auch Driftkorrektur) wird durch integrierte Referenzpunkte ermöglicht. Hinzu kommt, dass die Substrathalter derart gestaltet sein können, dass das Gesamtgewicht für Substrathalter und eingelegtes Substrat für die unterschiedlichen Substrattypen immer in etwa gleich ist. Dadurch können Verzerrungen und Deformationen am X/Y-Schlitten und am Spiegelkörper in erster Näherung konstant gehalten werden. Dazu sind entsprechende Programme in einer Recheneinheit des Messgeräts vorgesehen, die diese konstanten, externen Einflüsse korrigieren.

Ein Ausführungsbeispiel der Erfindung wird nachfolgend anhand der Zeichnungen näher erläutert.

Es zeigen:
- Fig. 1:: eine schematische Seitenansicht des Messgeräts,
- Fig. 2: eine perspektivische Darstellung von Substrat, Substrathalter und Spiegelkörper des X/Y-Schlittens,
- Fig. 3: eine Draufsicht auf den Substrathalter und
- Fig. 4: eine Seitenansicht des Substrathalters zur Darstellung der Lage der Auflageelemente,
- Fig. 5: eine Detailansicht des in Fig. 3 mit X" bezeichneten Bereichs und
- Fig. 6: eine Detailansicht des in Fig. 4 mit Y" bezeichneten Bereichs.

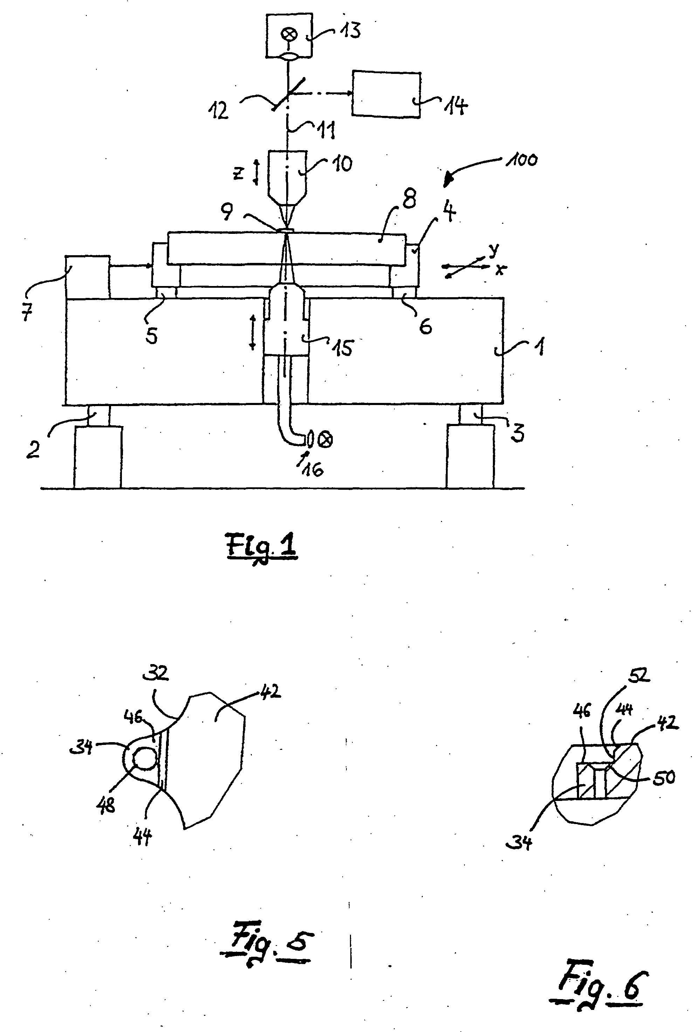

Das in Fig. 1 dargestellte hochgenaue Messgerät 100 besteht aus einem Granitblock 1, der auf Füßen 2, 3 schwingungsgedämpft gelagert ist. Auf dem Granitblock 1 ist ein X/Y-Schlitten (in dieser Ansicht nicht zu sehen) ausgebildet, der auf Luftlagem 5, 6 in den zwei durch Pfeile angedeuteten Richtungen gleitend verschiebbar ist. Ein Spiegelkörper 4 ist auf dem X/Y-Schlitten aufgesetzt und besteht vorteilhafterweise aus einer Glaskeramik mit geringem thermischen Ausdehnungskoeffizienten. Selbstverständlich können auch andere Materialien verwendet werden, die eine entsprechend der Genauigkeit des Messgeräts angepasste Wärmeausdehnungseigenschaft besitzen. Die Antriebe für den X/Y-Schlitten sind nicht dargestellt. Die Position des X/Y-Schlittens bzw. des Spiegelkörpers 4 wird mit einem Laserinterferometersystem 7 in X- und Y-Richtung gemessen.

In den Spiegelkörper 4 des X/Y-Schlittens ist ein Substrathalter 8 mit Substrat (nicht dargestellt) eingelegt. Das Substrat besteht z. B. aus Quarzglas. Auf der Substratoberfläche sind Strukturen 9 aufgebracht. Da der Spiegelkörper des X/Y-Schlittens 4 als Rahmen ausgebildet ist, kann das Substrat auch von unten her durchleuchtet werden. Bei nicht lichtdurchlässigen Substraten findet dann eine Beleuchtung mit Auflicht Anwendung. Die weitere Beschreibung beschränkt sich auf die Beleuchtung von lichtdurchlässigen Substraten.

Oberhalb des Substrats befindet sich ein Abbildungssystem 10 hoher optischer Güte, das zur Fokussierung längs seiner optischen Achse 11 in Z-Richtung verstellbar ist. Über einen Teilerspiegel 12 wird zum einen das Licht einer Lichtquelle 13 in den optischen Strahlengang eingeleitet und zum anderen werden die Abbildungsstrahlen auf eine Detektoreinrichtung 14 gelenkt. Die Detektoreinrichtung 14 ist z. B. eine CCD-Kamera mit hochauflösendem Pixelarray. Die Lichtquelle 13 emittiert im nahen UV-Spektralbereich. In den Granitblock 1 ist eine weitere Beleuchtungseinrichtung eingesetzt, die aus einem höhenverstellbaren Kondensor 15 und einer Lichtquelle 16 besteht. Als Lichtquelle 16 kann auch die Austrittsfläche eines Lichtleiters vorgesehen sein. Die optische Achse des Kondensors 15 fluchtet mit der optischen Achse 11 des Abbildungssystems 10. Die Höhenverstellung des Kondensors 15 mit Lichtquelle 16 dient der Anpassung der auf die Strukturen 9 zu richtenden Beleuchtungsstrahlen an unterschiedliche optische Dicken der Substrate. Der Kondensorkopf kann insbesondere in den offenen Teil des Rahmens des X/Y-Schlittens 4 hineinreichen.

Fig. 2 zeigt in einer perspektivischen Darstellung, wie der Spiegelkörper 4 des X/Y-Schlittens, der Substrathalter 8 und das Substrat 20 im räumlichen Zusammenhang zueinander stehen. Im Spiegelkörper 4 ist eine Aussparung 4a ausgeformt. Um die Aussparung 4a herum ist ein Rand 22 ausgebildet. Im Rand 22 sind mehrere Bohrungen 24 vorgesehen, durch die hindurch Abstandsstifte 26 eingesetzt sind. An einem Ende tragen die Abstandsstifte 26 je ein kugelförmiges Element 28. In dem bevorzugten Ausführungsbeispiel sind die Bohrungen 24 (drei Stück) derart am Rand 22 verteilt, dass sie auf den Eckpunkten eines gleichschenkligen Dreiecks liegen. Der Substrathalter 8 wird in den Spiegelkörper 4 eingesetzt und kommt dabei auf den kugelförmigen Abrundungen 28 der Abstandsstifte 26 zu ruhen. In dem in Fig. 2 dargestellten Ausführungsbeispiel ist ein Typ eines Substrathalters dargestellt, der für die Aufnahme eines Substrats 20 eines Typs geeignet ist.

Die Substrathalter 8 für unterschiedliche Substrattypen besitzen gleiche Außenabmessungen und unterscheiden sich lediglich in der Form einer Aussparung 30, die im Substrathalter 8 ausgeformt ist. Entsprechend der Größe und des Typs der zu untersuchenden Substrate 20 ist die Aussparung 30 im Substrathalter 8 ausgebildet. Die Aussparung 30 des Substrathalters 8 definiert einen umlaufenden Rand 32, an dem Auflageelemente für das Substrat 20 ausgeformt sind. Das Substrat 20 kommt derart auf den Auflageelementen zu ruhen, dass die Substratunterseite ebenfalls frei zugänglich ist.

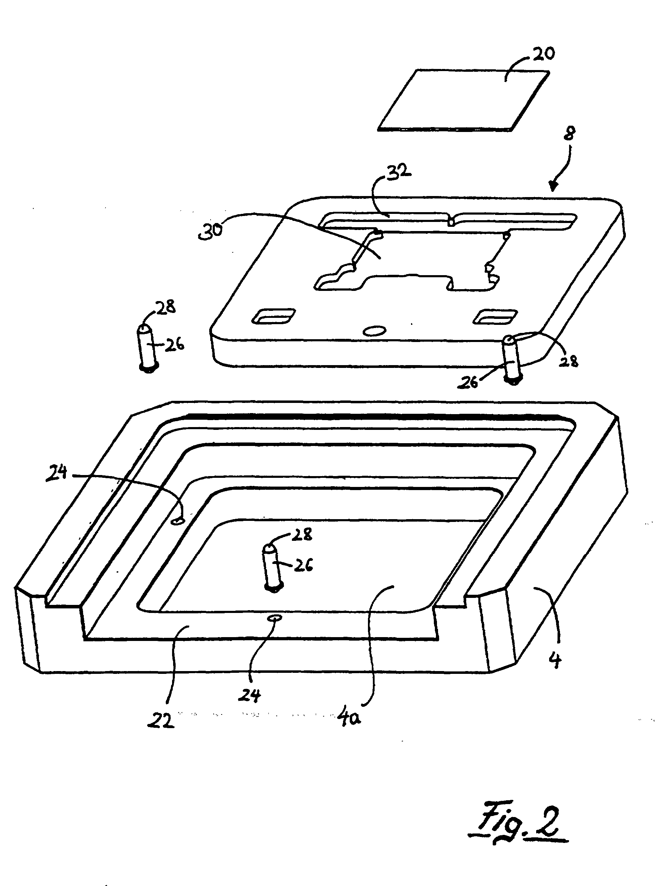

Fig. 3 zeigt eine Draufsicht auf den erfindungsgemäßen Substrathalter 8. Am umlaufenden Rand 32 der Aussparung 30 sind mehrere Auflageelemente 34 ausgeformt. Der mit dem Bezugszeichen X" bezeichnete Kreis in Fig. 3 ist als Detaildarstellung in Fig. 5 dargestellt. Im Substrathalter 8 sind zwei weitere Aussparungen 36 vorgesehen, die zur Führung während des Transports dienen. Im vorliegenden Ausführungsbeispiel sind drei Auflageelemente 34 am umlaufenden Rand 32 der Aussparung 30 ausgebildet. Die Auflageelemente 34 sind derart angeordnet, dass sie sich auf den Eckpunkten eines gedachten gleichschenkligen Dreiecks befinden. Der Substrathalter 8 definiert eine Oberseite 42, auf der eine Codierung 38 vorgesehen ist. Zusätzlich zur Codierung können auf der Oberseite 42 mehrere Referenzmarken 40 vorgesehen sein. Die Codierung 38 kann z. B. eine Typkennzeichnung des Substrathalters 8 vorsehen. Die Typkennzeichnung kann in Form eines Punktecodes, einer DOT-Matrix, eines Barcodes oder einer lesbaren Aufschrift vorgesehen sein. Die Referenzmarken können zur Langzeitüberwachung hinsichtlich von Driftüberwachung und Driftkorrektur verwendet werden. Ferner sind am umlaufenden Rand 32 der Aussparung 30 mehrere reflektierende Elemente 35 angebracht, die von Rand 32 in etwa in die Aussparung 30 hineinreichen. Diese reflektierenden Elemente 35 werden zur Bestimmung der Centrality des in den Substrathalter 8 eingelegten Substrats 20 verwendet.

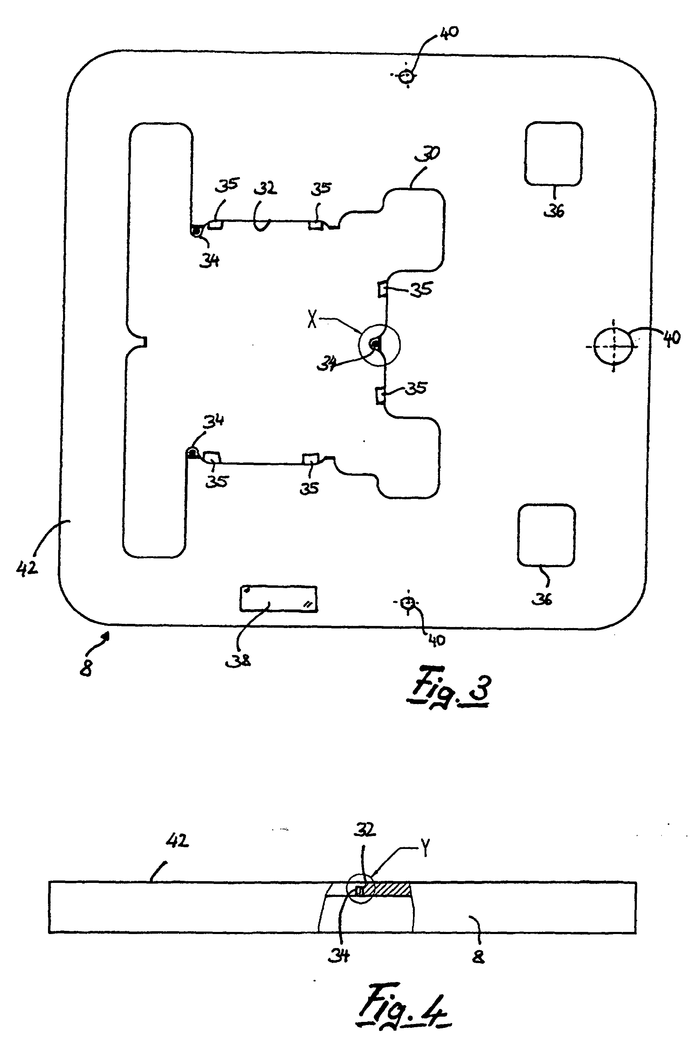

Fig. 4 zeigt eine Seitenansicht des Substrathalters 8, wobei Teile des Substrathalters weggelassen sind, um einen besseren Einblick in die Ausgestaltung der Auflageelemente 34 zu erhalten. Der in Fig. 4 mit Y" bezeichnete Kreis ist in Fig. 6 in einer Detailansicht vergrößert dargestellt. Die Auflageelemente 34 sind in Form von Nasen bzw. Vorsprüngen am umlaufenden Rand 32 der Aussparung 30 ausgebildet.

Fig. 5 ist die Detailansicht des Bereichs aus Fig. 3. Am umlaufenden Rand 32 der Aussparung 30 sind die Auflageelemente 34 ausgebildet. Die Auflageelemente 34 liegen tiefer als die flache Oberseite 42 des Substrathalters 8. Im Bereich des Auflageelements 34 ist der umlaufende Rand 32 mit einer Abschrägung 44 versehen, die somit das Einlegen eines Substrats 20 in die Aussparung 30 des Substrathalters 8 erleichtert. Das Aufnahmeelement 34 definiert ebenfalls eine flache Oberseite 46. In der flachen Oberseite 46 ist eine Rubinkugel 48 eingesetzt, auf der das Substrat 8 mit einem kleinen Randbereich zu liegen kommt.

Fig. 6 zeigt die Detailansicht aus Fig. 4. Von der flachen Oberseite 42 des Substrathalters 8 führt die Abschrägung 44 des umlaufenden Randes 32 im Bereich des Aufnahmeelements 34 zu einer Anschlagskante 52, die ihrerseits auf der flachen Oberseite 46 des Auflageelements 34 endet. In der flachen Oberseite 46 des Auflageelements 34 ist eine kreisförmige Vertiefung 50 ausgebildet, in die eine Rubinkugel (nicht dargestellt) eingesetzt ist. Wie bereits in Fig. 5 erwähnt, bilden die Rubinkugeln die Auflagepunkte für das in den Substrathalter 8 eingesetzte Substrat 20. Der Abstand von der Oberseite der Rubinkugel 48 zur flachen Oberseite 42 des Substrathalters ist derart ausgelegt, dass er im Wesentlichen der Normdicke des zum Substrathalter 8 passenden Substrattyps entspricht. Der Ausdruck im Wesentlichen der Normdicke" bedeutet, dass der Abstand der Normdicke plus der durch die Norm festgelegten Dickenschwankung entspricht. Die für die Substrate 20 heranzuziehende Norm (oder Standard) ist der SEMI-Standard (SEMI P1-92 © SEMI, 1981, 1999).

## Patentansprüche

1. Ein Substrathalter (8) eines Substrats (20) umfasst:
a) einen einstückigen Rahmen mit flacher Oberseite (42) und einer Aussparung (30) mit einem umlaufenden Rand (32) und
b) drei Auflageelemente (34), die am umlaufenden Rand (32) der Aussparung (34) ausgeformt sind, auf denen Kugeln angebracht sind, auf denen das Substrat (20) ruht, und der Abstand von der Oberseite der Kugel zur flachen Oberseite (42) des Substrathalters (8) im Wesentlichen der Normdicke des verwendeten Substrattyps entspricht.

2. Substrathalter nach Anspruch 1, wobei die auf dem Auflageelement vorgesehene Kugel eine punktförmige Auflage darstellt und dass die punktförmigen Auflagen derart am umlaufenden Rand (32) der Aussparung (30) angeordnet sind, dass die punktförmigen Auflagen die Eckpunkte eines gleichschenkligen Dreiecks bilden.

3. Substrathalter nach Anspruch 1, wobei am umlaufenden Rand (32) des Substrathalters (8) reflektierende Elemente (35) derart angebracht sind, dass diese in die Aussparung (34) des Substrathalters (8) hineinreichen, dass die Außenabmessungen des Substrathalters (20) für alle Substrattypen gleich sind, und dass die Aussparung (30) bezüglich der Größe des verwendeten Substrattyps ausgestaltet ist, dass auf der flachen Oberseite (42) des Substrathalters (8) eine Codierung (38) vorgesehen ist, und dass auf der flachen Oberseite (42) des Substrathalters (8) mindestens eine Referenzmarke (40) vorgesehen ist.

4. Substrathalter nach Anspruch 1, der in den Spiegelkörper (4) eines X/Y-Schlittens einsetzbar ist, wobei im Spiegelkörper (4) eine Aussparung definiert ist, um die herum ein Rand (22) vorgesehen ist, auf dem mehrere Abstandsstifte (26) mit einer kugelförmigen Abrundung (28) angebracht sind, so dass der Substrathalter (8) auf den kugelförmigen Abrundungen (28) ruht.

5. Substrathalter nach Anspruch 4, wobei die Abstandsstifte (26) am umlaufenden Rand (22) des Spiegelkörpers (4) derart verteilt sind, dass sie auf den Eckpunkten eines gleichschenkligen Dreiecks vorgesehen sind.

6. Verwendung des Substrathalters nach einem der Ansprüche 1 bis 5 in einem hochgenauen Messgerät, wobei der Substrathalter (8) zur Bestimmung der Abweichung von der Normdicke bei Substraten eines Typs geeignet ist.

7. Verfahren zur Bestimmung der Dickenabweichung eines Substrats von einer vorgegebenen Normdicke:
a) Einlegen eines Substrats in eine Aussparung (30) eines für das Substrat vorgesehenen Substrathalters (8), der eine flache Oberseite (42) aufweist,
b) Fokussieren auf die Oberfläche des Substrats (20) und Registrieren der Fokuslage,
c) Fokussieren auf die flache Oberseite (42) des Substrathalters (8) und Registrieren der Fokuslage, und
d) Ermitteln der Dickenabweichung des Substrats (20) aus der Differenz der beiden Fokuslagen.

8. Verfahren nach Anspruch 7, wobei die ermittelte Dickenabweichung des Substrats (20) von der Normdicke in einen dafür vorgesehenen Speicher einer Elektronikeinheit abgelegt wird, und dass diese Dickenabweichung aus dem elektronischen Speicher für spätere Rechnungen abrufbar ist.

9. Verfahren nach Anspruch 8, wobei der Typ des verwendeten Substrathalters (8) mittels einer Codierung (38), die auf der flachen Oberseite (42) des Substrathalters (8) vorgesehen ist, ermittelt wird, und dass das Substrat (20) in der Aussparung (30) des Substrathalters (8) durch Auflageelemente (34) gehalten wird, wobei auf den Auflageelementen (34) jeweils eine Rubinkugel (48) vorgesehen ist, auf der das Substrat (20) ruht.

10. Verfahren nach Anspruch 9, wobei der Abstand von der Oberseite der Rubinkugel (48) zur flachen Oberseite (42) des Substrathalters (8) im Wesentlichen der Normdicke des verwendeten Substrattyps entspricht und dass die Auflageelemente (34) am umlaufenden Rand (32) der Aussparung (30) derart angeordnet sind, dass sie sich an den Eckpunkten eines gleichschenkligen Dreiecks befinden.

## Claims

1. A substrate holder (8) of a substrate (20) comprises:
a) a one-piece frame having a flat upper surface (42) and an opening (30) having a peripheral rim (32), and
b) three support elements (34), which are shaped on the peripheral rim (32) of the opening (34), on which there are mounted spheres on which the substrate (20) rests, and the distance from the upper surface of the sphere to the flat upper surface (42) of the substrate holder (8) corresponds substantially to the standard thickness of the substrate type used.

2. Substrate holder according to Claim 1, wherein the sphere provided on the support element constitutes a point-like support, and wherein the point-like supports are arranged on the peripheral rim (32) of the opening (30) in such a way that the point-like supports form the vertices of an equilateral triangle.

3. Substrate holder according to Claim 1, wherein reflective elements (35) are mounted on the peripheral rim (32) of the substrate holder (8) in such a way that these reach into the opening (34) in the substrate holder (8), wherein the external dimensions of the substrate holder (20) are the same for all substrate types, and wherein the opening (30) is configured with respect to the size of the substrate type used, wherein a code (38) is provided on the flat upper surface (42) of the substrate holder, and wherein at least one reference mark (40) is provided on the flat upper surface (42) of the substrate holder (8).

4. Substrate holder according to Claim 1, which can be inserted into the reflective body (4) of an X/Y carriage, there being defined in the reflective body (4) an opening around which a rim (22) is provided, on which a plurality of spacer pins (26) with a spherical rounded portion (28) are mounted, so that the substrate holder (8) rests on the spherical rounded portions (28).

5. Substrate holder according to Claim 4, the spacer pins (26) being distributed on the peripheral rim (22) of the reflective body (4) in such a way that they are provided at the vertices of an equilateral triangle.

6. Use of the substrate holder according to one of Claims 1 to 5 in a highly precise measuring instrument, wherein the substrate holder (8) is suitable for determining the deviation from the standard thickness in substrates of one type.

7. Procedure for determining the thickness deviation of a substrate from a predefined standard thickness:
a) placing a substrate in an opening (30) in a substrate holder (8) which is provided for the substrate and which has a flat upper surface (42),
b) focusing on the surface of the substrate (20) and registering the focus position,
c) focusing on the flat upper surface (42) of the substrate holder (8) and registering the focus position, and
d) determining the thickness deviation of the substrate (20) from the difference between the two focus positions.

8. Procedure according to Claim 7, wherein the deviation determined of the thickness of the substrate (20) from the standard thickness is stored in a memory provided for the purpose in an electronics unit, and wherein this thickness deviation can be retrieved from the electronic memory for subsequent calculations.

9. Procedure according to Claim 8, wherein the type of substrate holder (8) used is determined by means of a code (38) which is provided on the flat upper surface (42) of the substrate holder (8), and wherein the substrate (20) is held in the opening (30) in the substrate holder (8) by support elements (34), in each case a ruby sphere (48), on which the substrate (20) rests, being provided on the support elements (34).

10. Procedure according to Claim 9, wherein the distance from the upper surface of the ruby sphere (48) to the flat upper surface (42) of the substrate holder (8) corresponds substantially to the standard thickness of the substrate type used, and wherein the support elements (34) are arranged on the peripheral rim (32) of the opening (30) in such a way that they are located at the vertices of an equilateral triangle.

## Revendications

1. Support de substrat (8) d'un substrat (20) comprenant :
a) un cadre d'une seule pièce avec un côté supérieur (42) plat et un évidement (30) avec un bord (32) périphérique et
b) trois éléments de support (34) qui sont formés sur le bord (32) périphérique de l'évidemment (34), sur lesquels sont placées des billes sur lesquelles le substrat (20) repose, et la distance du côté supérieur de la bille au côté supérieur (42) plat du support de substrat (8) correspond sensiblement à l'épaisseur standard du type de substrat utilisé.

2. Support de substrat selon la revendication 1, dans lequel la bille prévue sur l'élément de support représente un support ponctuel et en ce que les supports ponctuels sont disposés sur le bord (32) périphérique de l'évidement (30) de telle sorte que les supports ponctuels forment les sommets d'un triangle isocèle.

3. Support de substrat selon la revendication 1, dans lequel sur le bord (32) périphérique du support de substrat (8) sont placés des éléments (35) réfléchissants de telle sorte que ceux-ci entrent dans l'évidement (34) du support de substrat (8), que les dimensions extérieures du support de substrat (20) sont identiques pour tous les types de substrat, et que l'évidement (30) est conçu par rapport à la grandeur du type de substrat utilisé, qu'un codage (38) est prévu sur le côté supérieur (42) plat du support de substrat (8) et qu'au moins un repère de référence (40) est prévu sur le côté supérieur (42) plat du support de substrat (8).

4. Support de substrat selon la revendication 1, qui peut être inséré dans le corps de miroir (4) d'un chariot X/Y, un évidement étant défini dans le corps de miroir (4), évidement autour duquel est prévu un bord (22) sur lequel sont placées plusieurs goupilles d'espacement (26) avec un arrondi (28) sphérique, de sorte que le support de substrat (8) repose sur les arrondis (28) sphériques.

5. Support de substrat selon la revendication 4, dans lequel les goupilles d'espacement (26) sont réparties sur le bord (22) périphérique du corps de miroir (4) de telle sorte qu'elles sont prévues sur les sommets d'un triangle isocèle.

6. Utilisation du support de substrat selon l'une quelconque des revendications 1 à 5, dans un appareil de mesure très précis, dans lequel le support de substrat (8) est approprié pour la détermination de l'écart par rapport à l'épaisseur standard pour des substrats d'un type.

7. Procédé pour la détermination de l'écart d'épaisseur d'un substrat par rapport à une épaisseur standard prédéfinie, le procédé comprenant les étapes suivantes :
a) insertion d'un substrat dans un évidement (30) d'un support de substrat (8) prévu pour le substrat qui présente un côté supérieur (42) plat,
b) concentration sur la surface du substrat (20) et enregistrement de la position du foyer,
c) concentration sur le côté supérieur (42) plat du support de substrat (8) et enregistrement de la position du foyer, et
d) détermination de l'écart d'épaisseur du substrat (20) à partir de la différence des deux positions de foyer.

8. Procédé selon la revendication 7, dans lequel l'écart d'épaisseur déterminée du substrat (20) par rapport à l'épaisseur standard est déposé dans une mémoire prévue à cet effet d'une unité électronique et que cet écart d'épaisseur peut être appelé dans la mémoire électronique pour des calculs ultérieurs.

9. Procédé selon la revendication 8, dans lequel le type du support de substrat utilisé (8) est calculé au moyen d'un codage (38) qui est prévu sur le côté supérieur (42) plat du support de substrat (8), et que le substrat (20) est maintenu dans l'évidement (30) du support de substrat (8) par des éléments de support (34), une bille de rubis (48), sur laquelle repose le substrat (20), étant prévue à chaque fois sur les éléments de support (34).

10. Procédé selon la revendication 9, dans lequel la distance du côté supérieur de la bille de rubis (48) au côté supérieur (42) plat du support de substrat (8) correspond sensiblement à l'épaisseur standard du type de substrat utilisé et que les éléments de support (34) sont disposés sur le bord (32) périphérique de l'évidement (30) de telle sorte qu'ils se trouvent sur les sommets d'un triangle isocèle.
